# EUROPEAN PATENT APPLICATION

(11) **EP 2 509 124 A1**
(43) Date of publication of application: **10.10.2012**
(21) Application number: 10834269.2
(22) Date of filing: 03.12.2010
(51) Int. Cl.: H01L 39/24, C23C 18/02, C01F 17/00

(54) **METHOD FOR OBTAINING SUPERCONDUCTING TAPES FROM METAL-ORGANIC SOLUTIONS HAVING LOW FLUORINE CONTENT**

(30) Priority: 04.12.2009 ES 200931114
(71) Applicant: Consejo Superior De Investigaciones Científicas (CSIC), 28006 Madrid (ES)
(72) Inventor: RICART MIRÓ, Susana, E-08193 Cerdanyola del Vallès (Barcelona) (ES); PALMER PARICIO, Xavier, E-08193 Cerdanyola del Vallès (Barcelona) (ES); POMAR BARBEITO, Alberto, E-08193 Cerdanyola del Vallès (Barcelona) (ES); PUIG MOLINA, Teresa, E-08193 Cerdanyola del Vallès (Barcelona) (ES); OBRADORS BERENGUER, Xavier, E-08193 Cerdanyola del Vallès (Barcelona) (ES); PALAU MASOLIVER, Anna, E-08193 Cerdanyola del Vallès (Barcelona) (ES)
(74) Representative: Pons Ariño, Angel
(86) International application number: PCT/ES2010/070798
(87) International publication number: WO 2011/067453

(57) **Abstract**

The present invention relates to the obtainment of a solution of metal-organic precursors having a maximum fluorine content of 10%, using the solution previously described in patent ES2259919 B1 as a starting point. This modification allows the heat treatment of the superconducting layers, namely decomposition (pyrolysis) and crystalline growth, to be performed in a single step. Furthermore, the low fluorine content allows the risks of toxicity and corrosion to be minimsed.

## Description

The present invention refers to obtaining a solution of metal-organic precursors with a maximum fluorine content of 10 % using the solution previously described in patent ES2259919 B1 as the starting point. This modification enables carrying out the thermal treatment of superconducting decomposition layers (pyrolysis) and crystal growth in a single stage. In addition, the low fluorine content reduces the risks of toxicity and corrosion.

### STATE OF PRIOR ART

High temperature superconducting materials have huge potential for use in a wide variety of technologies. However, it is an essential requirement to develop methodologies for obtaining high performance superconductors, particularly those that can transport high electrical currents without losses, including under high magnetic fields. The first high temperature conductors developed were based on BiSrCaCuO-type phases and these were called first generation superconductors (1G). The development of such materials saw a major revolution with the discovery of a new methodology for the preparation of a second generation (2G) of conductors based on REBa₂Cu₃O₇-type materials (REBCO, where RE = rare earth or yttrium), called epitaxial superconductors (or coated conductors).

In recent years, various methodologies have been developed for obtaining epitaxial superconductors based on different multi-layer architectures with high potential in many fields for high current and high temperature applications. Various strategies have been followed for preparing these 2G conductors mainly based on methodologies of vacuum deposition of epitaxial layers on metal substrates. These substrates can have a textured oxide template, deposited by Ion Beam Deposition (IBD) on a polycrystalline substrate or are composed of textured buffer layers, which replicate the texture achieved in substrates via thermomechanical treatments such as the so-called Rolling Assisted Biaxial Texturing (RABiTs). Other interesting approaches are where the textured buffer layer is achieved by Surface Oxidation Epitaxy, SOE) or by deposition by inclined evaporation (Inclined Surface Deposition, ISD).

After these textured substrates have been obtained, deposition of epitaxial oxides is carried out in the form of a multilayer, which acts as a buffer to atomic diffusion and oxidation, and of the REBCO superconducting layer, in which the electric current is transported. In order to prepare these multilayer structures, techniques of vacuum deposition (evaporation, laser ablation, sputtering) or techniques of chemical solution deposition (CSD) based on metal-organic chemical solutions can be used. The latter are particularly interesting due to the possibilities of developing low cost epitaxial superconductors.

The demonstration of the possibility of using trifluoroacetate (TFA) precursors to grow the YBCO superconductor has been widely described as a very important step forward (A. Gupta, R. Jagannathan, E.I.Cooper, E.A.Giess, J.I.Landman, B.W.Hussey, Superconducting oxide films with high transition temperature prepared from metal trifluoroacetate precursors, Appl. Phys. Lett. 52, 1988, 2077; P. C. McIntyre, M. J. Cima, and M. F. Ng, Metalorganic deposition of high-J Ba YCu O thin films from trifluoroacetate precursors onto (100) SrTiO3, J. Appl. Phys. 68, 1990, 4183). These precursors have BaF₂, Y₂O₃ and CuO as final products after the decomposition of the metal-organic precursors and therefore prevent the formation of BaCO₃, which enables growing thin YBCO films at lower temperatures. Recently, a new methodology for obtaining anhydrous TFA precursors for obtaining high quality films at the same time as reducing the time required for processing the films and increasing the stability of the precursor solution has been described in patent ES2259919 (B1) and in the international patent application WO 2006/103303.

One of the current objectives is to improve the processes from the environmental point of view, that is, the use of precursor salts and solvents with the smallest possible impact, both from the toxicological and energy points of view. Thus systems have been described for reducing the presence of fluorine in the precursor salts (Dawley, Clem *et al.* 2001; T. Dawley 2002; Xu, Goyal *et al.* 2004; Seleznev and Cima 2005), as well as reducing the thermal treatment times using various types of additives (T. Dawley 2002; Dawley, Clem *et al.* 2004).

### DESCRIPTION OF THE INVENTION

The present invention provides a process for obtaining superconducting materials through the use of a solution of metal-organic precursors with lower fluorine content and with stabilising organic additives. The process enables obtaining high quality superconducting materials easily, given that the improvement in the thermal treatment for the preparation of the superconducting layers makes it possible to carry out pyrolysis and crystal growth in a single stage. In addition, the low fluorine content reduces the risks of toxicity. A first aspect of the present invention refers to a process for obtaining a superconducting material comprising deposition from a precursor solution that comprises at least one rare earth or yttrium salt, at least one alkaline earth metal salt and at least one transition metal salt, characterised in that the maximum proportion by weight of fluorine compared to the total weight of the precursor salts is 10 %. This implies a reduction in fluorine content of 70 % compared to the fluorine content of a standard solution known in the state of the art, which starts from yttrium, barium and copper trifluoroacetates. The minimum fluorine content is that corresponding to the formation of barium fluoride for all the initial barium in the pyrolyzed layer.
In a preferred embodiment, the total concentration of metal ions in the solution is between 0.5 and 2.5 M.

The rare earth salt preferably comprises at least one element selected from Y, La, Nd, Sm, Eu, Gd, Dy, Ho, Er, Yb, Lu and any of their combinations. More preferably, the salt is of Y, Gd, Eu, Dy and any of their combinations. The counterion of this rare earth or yttrium salt may be monofluoro-carboxylate, difluoro-carboxylate, trifluoroacetate, non-fluorinated carboxylate or combinations of these. Still more preferably, the rare earth or yttrium salt is a trifluoroacetate. The alkaline earth metal in a preferred embodiment is selected from Ba, Sr, Ca and any of their combinations, and in a more preferred embodiment the alkaline earth metal is Ba. In a more preferred embodiment, the salt of the alkaline earth is a non-fluorinated carboxylate.

The salt of the transition metal is preferably of Cu and more preferably the salt of the transition metal is a non-fluorinated carboxylate.

In a preferred embodiment, the solution comprises at least one solvent selected from acetic acid, acetone, acetonitrile, benzene, 1-butanol, 2-butanol, 2-butanone, pentanone, t-butyl alcohol, carbon tetrachloride, chlorobenzene, chloroform, cyclohexane, 1,2-dichloroethane, diethyl ether, diethylene glycol, diethylene glycol dimethyl ether, 1,2-dimethoxyethane, dimethyl ether, dimethyl formamide, dimethyl sulfoxide, dioxane, ethanol, ethyl acetate, ethylene glycol, glycerine, heptane, triamide, hexane, methanol, methyl t-butyl ether, dichloromethane, N-methyl-2-pyrrolidone, N-methylpyrrolidone, nitromethane, pentane, petroleum ether, 1-propanol, 2-propanol, pyridine, tetrahydrofuran, toluene, triethylamine, o-xylene, m-xylene, p-xylene and any of their combinations. In a more preferred embodiment the solvent is selected from methanol, ethanol, isopropanol and any of their combinations. It a still more preferred embodiment, the solvent is ethanol.

The solution preferably comprises at least one stabilising additive constituted by carbon chains functionalised with alcohol, amino, ether and carbonyl groups, either alone or in combinations or forming part of polymeric chains. When it is an amino alcohol, it is preferably triethanolamine and when it is a urea, it is preferably N,N-dimethylurea. Still more preferably, the stabilising additive is added to the solution in a proportion of from 2 % to 20 % by weight.

The reduction in the amount of fluorine present in the standard process brings with it the consequent reduction of toxic and corrosive gases, which facilitates the industrial application of the process.

The presence of additives in the initial solution makes the superconducting tape less susceptible to environmental conditions such as humidity. Consequently, it is stable for longer storage times and the environmental requirements for its deposition are reduced compared to the usually described conditions.

The process of the present invention is characterised in that it preferably comprises the decomposition and crystal growth of the deposited product. Such thermal treatment is carried out in a single stage, more preferably at a temperature of between 70 and 900 °C. Still more preferably, this treatment is characterised by being carried out in a controlled atmosphere oven and comprises: a first heating that is carried out in an atmosphere of nitrogen with a water vapour pressure of between 7 and 100 mbar and an oxygen pressure of between 0.1 and 1 mbar to a temperature of between 750 and 820 °C; and a second heating at a temperature of between 300 and 500 °C at an oxygen pressure of 1 bar for a period of time less than 8 h, followed by cooling to room temperature.

The process takes place in a single temperature ramp of 5 to 100 °C/min up to the temperature of 750 to 820 °C.

In this way, the decomposition or pyrolysis of the starting metal-organic salts and subsequent crystal structure growth that takes place in the superconducting layer takes place in a single stage. This implies a global simplification of the process and a reduction of treatment times for possible large-scale application.

The superconducting material will preferably have a composition of AA'₂Cu₃O₇₋ₓ, where A is a rare earth or Y (yttrium), A' is an alkaline earth and x is between 0 and 1, where more preferably, A is selected from Y, La, Nd, Sm, Eu, Gd, Dy, Ho, Er, Yb, Lu and any of their combinations. Still more preferably, A is yttrium. A' is more preferably selected from Ba, Sr, Ca and any of their combinations. Still more preferably, A' is barium.

The superconducting material preferably has the formula YBa₂Cu₃O₇₋ₓ, where x is between 0 and 1.

In a preferred embodiment, the solution is deposited on a monocrystalline or biaxial textured substrate and in a more preferred embodiment, the substrate is selected from: a rare earth salt or oxide; an alkaline earth salt or oxide; a transition metal salt or oxide; and any of their combinations. In a yet more preferred embodiment, the substrate is selected from a list comprising monocrystals of SrTiO₃, LaAlO₃, zirconium, stabilised zirconium (YSZ), MgO, rare earth oxides and biaxially textured metal tapes.

In a second aspect, the present invention refers to a superconducting material obtainable according to the process described above in the present invention.

Preferably, the superconducting material has the formula YBa₂Cu₃O₇. This material is characterised by more preferably having a critical current of between 2 and 4 MA/cm² at 77 K and in the absence of external magnetic field, that is with the magnetic field produced by the sample itself or the auto-field.

In a third aspect, the present invention refers to a solution that comprises at least one rare earth or yttrium salt, at least one alkaline earth metal salt and at least one transition metal salt with a fluorine content in the solution of these salts of less than 10 % by weight.

In a preferred embodiment, these salts also include a stabilising additive such as those described above.

A fourth aspect of the present invention refers to the use of the solution for obtaining a superconducting material.

Throughout the description and the claims, the use of the word "comprise" and its variants is not intended to exclude other technical characteristics, additives, components or steps. For experts in the subject, other purposes, advantages and characteristics of the invention will follow in part from the description and in part from the practice of the invention. The following examples and figures are provided for illustration purposes and are not intended as limitations of the present invention.

### DESCRIPTION OF THE FIGURES

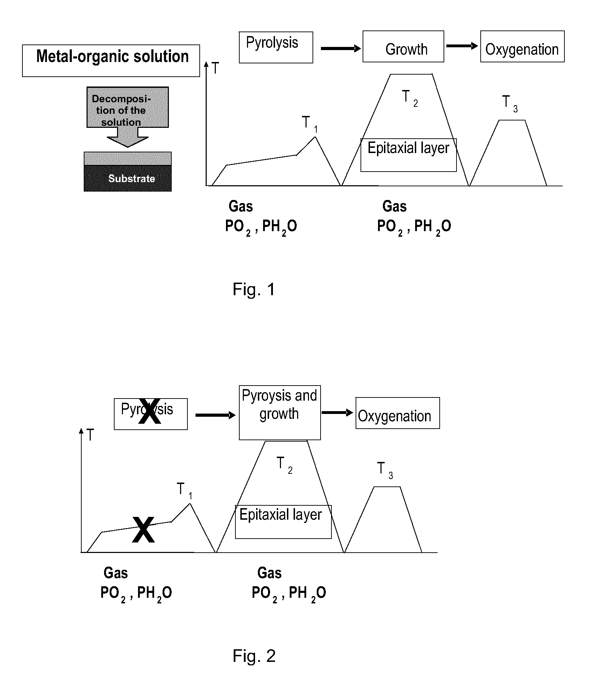

**Fig. 1****.** Thermal treatments of standard anhydrous solutions.
**Fig. 2****.** Thermal treatments of the modified solution with low fluorine content.
**Fig. 3****.** SEM image of a layer of YBCO grown from a modified solution with low fluorine content.

### EXAMPLES

The invention is illustrated below by some tests carried out by the inventors illustrating the specificity and effectiveness of the process for obtaining superconducting materials through the use of a solution of metal-organic precursors with lower fluorine content.

### Example 1

A solution was prepared of 50 ml Y trifluoroacetate, Ba 2,4-pentanedionate and Cu acetate with a total metal concentration of 1.5 M (ratio Y:Ba:Cu of 1:2:3). This was done by weighing 5.35 g (1.25 x 10⁻² moles) of Y(TFA)₃, 10.59 g (2.5 x 10⁻² moles) of Ba(acac)₂ and 6.81 g (1.75 x 10⁻² moles) of Cu(AcO)₂ that had been previously dried for 16 hours in an oven at 70 °C in a vacuum. The salts were dissolved in 20 ml methanol and 10 mL (7.5 x 10⁻² moles) of triethanolamine (TEA) were added over the mixture, adjusting the final volume to 50 mL with methanol.

This solution was deposited by the spin coating technique on a monocrystalline substrate of LaAlO₃ of dimensions 5x5 mm, thickness 0.5 mm and orientation (100). Next, thermal treatment was carried out to achieve the formation of the YBa₂Cu₃O₇ phase. This was performed in an oven where a rapid temperature rise (25 °C/min) was applied until reaching temperatures in the range of 790 - 815 °C. This temperature was maintained for 180 minutes (the last 30 minutes in the dry) and then a descending ramp was applied at a rate of 2.5 °C/min until reaching room temperature. In this case, the O₂ pressure was 0.2 mbar and of water pressure was 7 mbar. The gas flow was that permitted by the mass flow controller used (Bronkhorst High-Tech) for making the mixture, with a range of 0.012 to 0.6 l/min for N₂ and of between 0.006 and 0.03 l/min for O₂. Oxygenation of this sample was carried out using the same dry atmosphere without removing the sample from the oven. The temperature was raised to 450 °C, the carrier gas was changed to dry O₂ at 1 bar pressure and this temperature was maintained for a time of 90 minutes. Next, a descending temperature ramp was performed at 300 °C/h until reaching room temperature. The resulting layer was approximately 275 nm in thickness.

The sample was characterised by X-ray diffraction, SEM images and measurement of the critical current at 77 K and of the auto field (J_{c} = 3.6 x 10⁶ A/cm²). For reference values, the dependence of the critical current as a function of magnetic field applied perpendicularly to the substrate at 65 K was measured. It was found that J_{c} = 0.45 x 10⁶ A/cm² at 65 K and H=1 T.

### Example 2

A vial with a septum-type cap was filled with 6.60 g N,N-dimethylurea (7.5 x 10⁻² moles) and over this were added 20 ml of the YBCO solution in methanol prepared as in example 1. The mixture was stirred at room temperature and filtered through a 0.45 µm filter. The mixture thus prepared was preserved in an atmosphere of Ar.

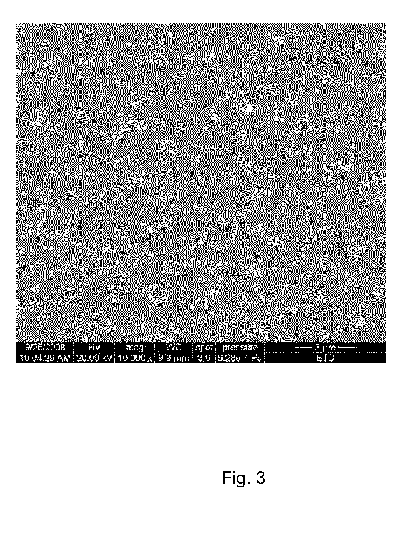

This solution of Y, Ba and Cu salts, containing 20 % of N,N-dimethylurea, was deposited on a LaO substrate under the same conditions indicated in Example 1. Thermal treatment of the deposited sample was carried out as described in Example 1 to result in the formation of the YBa₂Cu₃O₇ phase. The resulting layer was 200 nm in thickness. The sample was characterised by scanning electron microscope and by X-ray diffraction (Fig. 3).

### Example 3

The same process as described in Example 1 was followed except that ethanol was used as a solvent.

This solution of Y, Ba and Cu salts containing 20 % of TEA was deposited on a LaO substrate under the same conditions as indicated in Example 1. Thermal treatment of the deposited sample was carried out as described in Example 1 to result in the formation of the YBa₂Cu₃O₇ phase. The resulting layer was 200 nm in thickness. The sample was characterised by scanning electron microscope and by X-ray diffraction (Fig. 3).

### Example 4

The same process as described in Example 2 was followed and ethanol was used as a solvent.

This solution of Y, Ba and Cu salts containing 20 % of TEA was deposited on a LaO substrate under the same conditions as indicated in Example 1. Thermal treatment of the deposited sample was carried out as described in Example 1 to result in the formation of the YBa₂Cu₃O₇ phase. The resulting layer was 200 nm in thickness. The sample was characterised by scanning electron microscope and by X-ray diffraction (Fig. 3).

## Claims

1. Process for obtaining a superconducting material comprising deposition from a precursor solution that comprises at least one rare earth or yttrium salt, at least one alkaline earth metal salt and at least one transition metal salt, **characterised in that** the maximum proportion by weight of fluorine compared to the total weight of the precursor salts is 10 %.

2. Process according to claim 1 wherein the total concentration of metal ions in the solution is between 0.5 and 2.5 M.

3. Process according to any of the claims 1 or 2 wherein the rare earth salt comprises at least one element selected from Y, La, Nd, Sm, Eu, Gd, Dy, Ho, Er, Yb, Lu and any of their combinations.

4. Process according to claim 3 wherein the salt is of Y, Gd, Eu, Dy or any of their combinations.

5. Process according to any of the claims 3 or 4 wherein the rare earth or yttrium salt is selected from monofluoro-carboxylate, difluoro-carboxylate, trifluoroacetate, non-fluorinated carboxylate and combinations of these.

6. Process according to claim 5 wherein the rare earth or yttrium salt is trifluoroacetate.

7. Process according to any of the claims 1 to 6 wherein the alkaline earth metal is selected from Ba, Sr, Ca and any of their combinations.

8. Process according to claim 7 wherein the alkaline earth metal is Ba.

9. Process according to any of the claims 7 or 8 wherein the salt of the alkaline earth metal is a non-fluorinated carboxylate.

10. Process according to any of the claims 1 to 9 wherein the transition metal is Cu.

11. Process according to claim 10 wherein the salt of the transition metal is a non-fluorinated carboxylate.

12. Process according to any of the claims 1 to 11 wherein the solution comprises at least one solvent selected from acetic acid, acetone, acetonitrile, benzene, 1-butanol, 2-butanol, 2-butanone, pentanone, t-butyl alcohol, carbon tetrachloride, chlorobenzene, chloroform, cyclohexane, 1,2-dichloroethane, diethyl ether, diethylene glycol, diethylene glycol dimethyl ether, 1,2-dimethoxyethane, dimethyl ether, dimethyl formamide, dimethyl sulfoxide, dioxane, ethanol, ethyl acetate, ethylene glycol, glycerine, heptane, triamide, hexane, methanol, methyl t-butyl ether, dichloromethane, N-methyl-2-pyrrolidone, N-methylpyrrolidone, nitromethane, pentane, petroleum ether, 1-propanol, 2-propanol, pyridine, tetrahydrofuran, toluene, triethylamine, o-xylene, m-xylene, p-xylene and any of their combinations.

13. Process according to claim 12 wherein the solution comprises at least one solvent selected from methanol, ethanol, isopropanol and any of their combinations.

14. Process according to claim 13 wherein the solvent is ethanol.

15. Process according to any of the claims 1 to 14 wherein the solution comprises at least one stabilising additive constituted by carbon chains functionalised with alcohol, amino, ether and carbonyl groups, either alone or in combinations or forming part of polymeric chains.

16. Process according to claim 15 wherein the additive is selected from the list comprising amino alcohols, amino acids, ureas and any of their combinations.

17. Process according to claim 16 wherein the amino alcohol is triethanolamine.

18. Process according to claim 16 wherein the urea is N,N-dimethylurea.

19. Process according to any of the claims 15 to 18 wherein the stabilising additive is added to the solution in a proportion of between 2 % and 20 % by weight.

20. Process according to any of the claims 1 to 19 **characterised in that** it comprises the decomposition and crystal growth of the deposited product.

21. Process according to claim 20 wherein the decomposition and crystal growth take place between 70 and 900 °C.

22. Process according to any of the claims 20 or 21,**characterized in that** the decomposition and crystal growth are carried out in a controlled atmosphere oven and comprises: a first heating that is carried out in an atmosphere of nitrogen with a water vapour pressure of between 7 and 100 mbar and an oxygen pressure of between 0.1 and 1 mbar to a temperature of between 750 and 820 °C; and a second heating at a temperature of between 300 and 500 °C at an oxygen pressure of 1 bar for a period of time less than 8 h, followed by cooling to room temperature.

23. Process according to any of the claims 1 to 22 wherein the superconducting material has a composition of AA'₂Cu₃O₇₋ₓ, where A is a rare earth or Y, A' is an alkaline earth and x is between 0 and 1.

24. Process according to any of the claims 1 to 23 wherein A is selected from Y, La, Nd, Sm, Eu, Gd, Dy, Ho, Er, Yb, Lu and any of their combinations.

25. Process according to claim 24 wherein A is Y.

26. Process according to any of the claims 23 to 25 wherein A' is selected from Ba, Sr, Ca and any of their combinations.

27. Process according to claim 26 wherein A' is Ba.

28. Process according to any of the claims 23 to 27 wherein the superconducting material has the formula YBa₂Cu₃O₇₋ₓ, and x is between 0 and 1.

29. Process according to any of the claims 1 to 28 wherein the solution is deposited on a monocrystalline substrate or a substrate with a biaxial texture.

30. Process according to claim 29 wherein the substrate is selected from: a rare earth salt or oxide; an alkaline earth salt or oxide; a transition metal salt or oxide; and any of their combinations.

31. Process according to claim 30 wherein the substrate is selected from the list comprising monocrystals of SrTiO₃, LaAlO₃, zirconium, stabilised zirconium (YSZ), MgO, rare earth oxides and biaxially textured metal tapes.

32. A superconducting material obtainable as described in any of the claims 1 to 31.

33. A solution comprising at least one salt of a rare earth or of yttrium, at least one salt of an alkaline earth metal, at least one salt of a transition metal, with a fluorine content in these salts of less than 10 %.

34. A solution according to claim 33 wherein it additionally comprises a stabilising additive.

35. Use of the composition according to any of the claims 1 to 34 for obtaining a superconducting material.

36. A superconducting material of the formula YBa₂Cu₃O₇ obtainable as described in any of the claims 1 to 35.

37. The superconducting material according to claim 36 **characterised in that** it has a critical current density of between 2 and 4 MA/cm² at 77 K and the auto field.
